# EUROPEAN PATENT APPLICATION

(11) **EP 4 793 651 A1**
(43) Date of publication of application: **19.08.2026**
(21) Application number: 25864630.6
(22) Date of filing: 20.10.2025
(51) Int. Cl.: G01R 31/396, G01R 31/382, G01R 31/367, G01R 31/36, G01R 19/165

(54) **BATTERY DIAGNOSIS DEVICE AND METHOD THEREFOR**

(30) Priority: 20.12.2024 KR 20240192520
(71) Applicant: LG Energy Solution, Ltd., Seoul 07335 (KR)
(72) Inventor: HA, Chang Woo, Daejeon 34122 (KR); CHOI, Jee Soon, Daejeon 34122 (KR); KWON, Min Ho, Daejeon 34122 (KR); LEE, Kang Ho, Daejeon 34122 (KR)
(74) Representative: Goddar, Heinz J.
(86) International application number: PCT/KR2025/016594
(87) International publication number: WO 2026/134593

(57) **Abstract**

A battery diagnostic device according to an embodiment of the present disclosure may include a memory storing at least one instruction and at least one processor executing the at least one instruction, and the at least one processor may identify an individual vector representing a voltage of any one battery cell included in a battery unit at a specific point in time and a voltage change amount over a predetermined time interval after the specific point in time, identify, based on the individual vector, a specified number of reference vectors at each of a plurality of past points in time before the specific point in time, identify a first distribution characteristic among voltages of unit battery cells included in the battery unit, corresponding to the individual vector, and second distribution characteristics among voltages of the unit battery cells, corresponding to respective reference vectors, and set a diagnostic criterion for diagnosing the one battery cell based on the first distribution characteristic and the second distribution characteristics.

## Description

### TECHNICAL FIELD

### Cross-reference to Related Applications

This application claims priority from Korean Patent Application No. 10-2024-0192520, filed on December 20, 2024, the disclosure of which is incorporated by reference herein.

### Technical Field

Embodiments disclosed herein relate to a battery diagnostic device and a method thereof.

### BACKGROUND ART

As electric vehicles powered using electrical energy become more widespread, research and development into new vehicle architectures are actively underway. For example, an electric vehicle may be powered by a secondary battery, where the secondary battery is a rechargeable battery, including conventional Ni/Cd batteries, Ni/MH batteries, or the like, and recent lithium-ion batteries. Among secondary batteries, the lithium-ion battery has the advantage of having a much higher energy density than the existing Ni/Cd battery, Ni/MH battery, and the like. In addition, since the lithium-ion battery may be manufactured to be small and lightweight, the lithium-ion battery is used as a power source for mobile devices, and in recent years, its scope of use has expanded to include power sources for electric vehicles, so that the lithium-ion battery attracts attention as a next-generation energy storage medium.

In addition, in order to improve the stability and efficiency of the batteries, research on technologies for diagnosing a state of batteries is being conducted. In addition to technologies for diagnosing the state of batteries based on battery characteristics measured through sensors, technologies for increasing diagnostic accuracy and precision by diagnosing the state of batteries based on battery data are being developed.

### DISCLOSURE OF THE INVENTION

### TECHNICAL PROBLEM

According to embodiments disclosed herein, a battery diagnostic device for setting a diagnostic criterion of battery cells for each battery unit and a method thereof are provided.

According to the embodiments disclosed herein, a battery diagnostic device for setting a diagnostic criterion for battery cells for each battery unit by referring to data of battery cells at a past point in time and a method thereof are provided.

The technical problems of the present disclosure are not limited to those mentioned above, and other objectives not mentioned will be clearly understood by those skilled in the art from the following descriptions.

### TECHNICAL SOLUTION

A battery diagnostic device according to an embodiment of the present disclosure may include a memory storing at least one instruction and at least one processor executing the at least one instruction.

According to an embodiment of the present invention, the at least one processor may be configured to identify an individual vector representing a voltage of any one battery cell included in a battery unit at a specific point in time and a voltage change amount over a predetermined time interval after the specific point in time, identify, based on the individual vector, a specified number of reference vectors at each of a plurality of past points in time before the specific point in time, identify a first distribution characteristic among voltages of unit battery cells included in the battery unit, corresponding to the individual vector, and second distribution characteristics among voltages of the unit battery cells, corresponding to respective reference vectors, and set a diagnostic criterion for diagnosing the one battery cell based on the first distribution characteristic and the second distribution characteristics.

According to an embodiment of the present invention, the at least one processor may be configured to identify representative values of the first distribution characteristic and the second distribution characteristics, identify other representative values for other battery cells different from the battery cell among the unit battery cells at a specific point in time, corresponding to the representative values, and diagnose a state of the one battery cell included in the battery unit based on the representative values and the other representative values.

According to an embodiment of the present invention, the at least one processor may be configured to identify a specified number of reference vectors, among existing vectors representing the voltage of the one battery cell at each of the plurality of past points in time and the voltage change amount over the time interval after each of the plurality of past points in time, according to a similarity between each of the existing vectors and the individual vector.

According to an embodiment of the present invention, the at least one processor may be configured to identify the specified number of reference vectors among the existing vectors in order of proximity to the individual vector.

According to an embodiment of the present invention, the at least one processor may be configured to identify an average of the representative values and the other representative values, identify a threshold value that serves as the diagnostic criterion for diagnosing the one battery cell for abnormalities at the specific point in time based on the average, and diagnose the state of the one battery cell based on the threshold value.

According to an embodiment of the present invention, the at least one processor may be configured to identify the threshold value based on the average and a median value of the voltage change amounts of the respective unit battery cells at the specific point in time and diagnose the one battery cell for abnormalities based on the voltage change amount of the one battery cell being outside a threshold range identified based on the threshold value.

According to an embodiment of the present invention, the at least one processor may be configured to identify the individual vector by normalizing a vector including the voltage of the one battery cell at the specific point in time and the voltage change amount over the time interval after the specific point in time.

According to an embodiment of the present invention, the at least one processor may be configured to identify the existing vectors normalized at each of the plurality of past points in time and then stored in the memory by normalizing a vector including the voltage of the one battery cell at each of the plurality of past points in time and the voltage change amount over the time interval after each of the plurality of past points in time.

According to an embodiment of the present invention, the first distribution characteristic may include a first standard deviation between voltages corresponding to the individual vectors of the unit battery cells, and the second distribution characteristic may include a second standard deviation between voltages corresponding to the respective reference vectors of the unit battery cells.

According to an embodiment of the present invention, the at least one processor may be configured to identify representative values of the first distribution characteristic and the second distribution characteristics based on a value obtained by applying a first weight to the first standard deviation and values obtained by applying a second weight to each of second standard deviations.

According to an embodiment of the present invention, the at least one processor may be configured to identify the representative values based on the value obtained by applying the first weight to the first standard deviation and a sum of the values obtained by applying the second weight to each of the second standard deviations.

According to an embodiment, the first weight may be smaller than the second weight.

A battery diagnosis method according to another embodiment of the present invention may include identifying an individual vector representing a voltage of any one battery cell included in a battery unit at a specific point in time and a voltage change amount over a predetermined time interval after the specific point in time, identifying, based on the individual vector, a specified number of reference vectors at each of a plurality of past points in time before the specific point in time, identifying a first distribution characteristic among voltages of unit battery cells included in the battery unit, corresponding to the individual vector, and second distribution characteristics among voltages of the unit battery cell, corresponding to respective reference vectors and setting a diagnostic criterion for diagnosing the one battery cell based on the first distribution characteristic and the second distribution characteristics.

According to an embodiment of the present invention, the setting of the diagnostic criterion for diagnosing the one battery cell based on the first distribution characteristic and the second distribution characteristics may include identifying representative values of the first distribution characteristic and the second distribution characteristics, identifying other representative values for other battery cells different from the battery cell among the unit battery cells at a specific point in time, corresponding to the representative values, and diagnosing a state of the one battery cell included in the battery unit based on the representative values and the other representative values.

According to an embodiment of the present invention, the identifying, based on the individual vector, of the specified number of reference vectors at each of the plurality of past points in time before the specific point in time may include identifying a specified number of reference vectors, among existing vectors representing the voltage of the one battery cell at each of the plurality of past points in time and the voltage change amount over the time interval after each of the plurality of past points in time, according to a similarity between each of the existing vectors and the individual vector.

According to an embodiment of the present invention, the identifying of the specified number of reference vectors, among existing vectors representing the voltage of the one battery cell at each of the plurality of past points in time and the voltage change amount over the time interval after each of the plurality of past points in time, according to the similarity between each of the existing vectors and the individual vector may include identifying the specified number of reference vectors among the existing vectors in order of proximity to the individual vector.

According to an embodiment of the present invention, the diagnosing of the state of the one battery cell included in the battery unit based on the representative values and the other representative values may include identifying an average of the representative values and the other representative values, identifying a threshold value that serves as the diagnostic criterion for diagnosing the one battery cell for abnormalities at the specific point in time based on the average, and diagnosing the state of the one battery cell based on the threshold value.

According to an embodiment of the present invention, the identifying of the threshold value that serves as the diagnostic criterion for diagnosing the one battery cell for abnormalities at the specific point in time based on the average may include identifying the threshold value based on the average and a median value of the voltage change amounts of the respective unit battery cells at the specific point in time, and the diagnosing of the state of the one battery cell based on the threshold value may include diagnosing the one battery cell for abnormalities based on the voltage change amount of the one battery cell being outside a threshold range identified based on the threshold value.

According to an embodiment of the present invention, the identifying of the individual vector representing the voltage of the one battery cell included in a battery unit at the specific point in time and the voltage change amount over the predetermined time interval after the specific point in time may include identifying the individual vector by normalizing a vector including the voltage of the one battery cell at the specific point in time and the voltage change amount over the time interval after the specific point in time.

According to an embodiment of the present invention, the identifying of the specified number of reference vectors, among existing vectors representing the voltage of the one battery cell at each of the plurality of past points in time and the voltage change amount over the time interval after each of the plurality of past points in time, according to the similarity between each of the existing vectors and the individual vector may include identifying the existing vectors normalized at each of the plurality of past points in time and then stored in the memory by normalizing a vector including the voltage of the one battery cell at each of the plurality of past points in time and the voltage change amount over the time interval after each of the plurality of past points in time.

### ADVANTAGEOUS EFFECTS

The present technology can set a diagnostic criterion for battery cells for each battery unit.

In addition, the present technology can set a diagnostic criterion for battery cells for each battery unit by referring to data of battery cells at a past point in time.

Besides, various effects may be provided that are directly or indirectly identified through the present disclosure.

### BRIEF DESCRIPTION OF THE DRAWINGS

FIG. 1 is a block diagram illustrating a battery pack, in a battery diagnostic device and a battery diagnosis method according to an embodiment of the present disclosure.
FIG. 2 is a block diagram illustrating the configuration of a battery diagnostic device, in a battery diagnostic device and a battery diagnosis method according to an embodiment of the present disclosure.
FIG. 3 illustrates an example of individual vectors, existing vectors, and reference vectors, in a battery diagnostic device and a battery diagnosis method according to an embodiment of the present disclosure.
FIG. 4 illustrates an example of a flow of operations of a battery diagnostic device for storing a vector, in a battery diagnostic device and a battery diagnosis method according to an embodiment of the present disclosure.
FIG. 5 illustrates a flow of operations of a battery diagnostic device for diagnosing a state of a battery cell based on a threshold value, in a battery diagnostic device and a battery diagnosis method according to an embodiment of the present disclosure.
FIG. 6 illustrates a graph showing a voltage change amount over time, in a battery diagnostic device and a battery diagnosis method according to an embodiment of the present disclosure.
FIG. 7 illustrates a graph showing a value obtained by subtracting a median value from an voltage change amount over time, in a battery diagnostic device and a battery diagnosis method according to an embodiment of the present disclosure.
FIG. 8 illustrates a graph representing a value obtained by normalizing a value obtained by subtracting a median value from a voltage change amount, in a battery diagnostic device and a battery diagnosis method according to an embodiment of the present disclosure.
FIG. 9 illustrates a flow of operations of a battery diagnostic device for setting a diagnostic criterion, in a battery diagnostic device and a battery diagnosis method, according to an embodiment of the present disclosure.
FIG. 10 is a block diagram showing a hardware configuration of a computing system for performing a battery diagnosis method according to an embodiment of the present disclosure.

### MODE FOR CARRYING OUT THE INVENTION

Below, some embodiments disclosed herein are described with reference to the accompanying drawings of various embodiments of the present disclosure. However, this is not intended to limit the present technology to the specific embodiments, and it is to be construed to include various modifications, equivalents, and/or alternatives of embodiments of the present technology.

In adding reference numerals to the components of each drawing, it should be noted that the same components are given the same reference numerals as much as possible even though they are shown on different drawings. In addition, in describing various embodiments disclosed herein, when a detailed description of a related known configuration or function is determined to hinder understanding of the embodiments of the present invention, the detailed description thereof is omitted. It is to be understood that a singular form of a noun corresponding to an item may include one or more of the things, unless the relevant context clearly indicates otherwise.

In addition, in describing a component of the embodiments of the present disclosure, terms such as first, second, A, B, (a), (b), etc. may be used. These terms are only for distinguishing the component from other components, and the essence, sequence, or order of the component may not be limited by the terms. In addition, unless otherwise defined, all terms used herein, including technical or scientific terms, have the same meaning as commonly understood by those of ordinary skill in the art to which the embodiments disclosed herein belong. Terms, such as those defined in commonly used dictionaries, should be interpreted as having a meaning that is consistent with their meaning in the context of the related art and will not be interpreted in an idealized or overly formal sense unless expressly so defined herein.

In addition, in the present disclosure, in order to determine whether a specific condition is satisfied or fulfilled, expressions "more than" or "less than" may be used, but this is only a description for expressing an example and does not exclude descriptions of "equal to or more than" or "less than or equal to." A condition described as "equal to or more than" may be replaced with "more than," a condition described as "less than or equal to" may be replaced with "less than," and a condition described as "equal to or more than and less than" may be replaced with "more than and less than or equal to." In addition, hereinafter, "A to B" mean at least one of the elements from A (inclusive of A) to B (inclusive of B).

In the present disclosure, each of phrases such as "A or B," "at least one of A and B," "at least one of A or B," "A, B or C," "at least one of A, B and C," or "at least one of A, B, or C," may include any one of the items listed in the phrase, or all possible combinations of the phrases.

In the present specification, It is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or via a third element.

According to an embodiment, a method according to various embodiments disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the described components may include a single entity or multiple entities, and some of the plurality of entities may be disposed separately from other components. According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

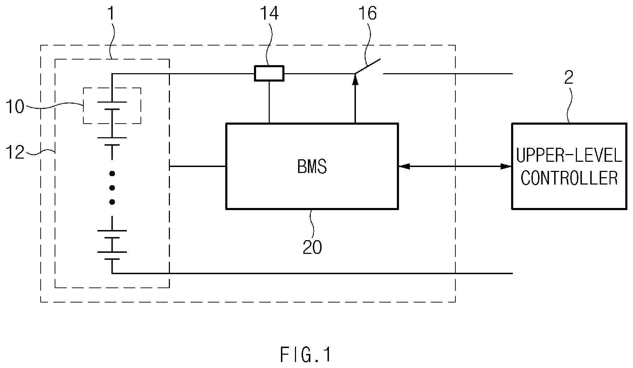

Hereinafter, embodiments of the present disclosure will be described in detail with reference to FIGS. 1 to 10.

FIG. 1 is a block diagram showing a battery pack, in a battery diagnostic device and a battery diagnosis method according to an embodiment of the present disclosure.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). For this purpose, the battery unit 12 may be electrically connected to the target device. Here, the target device may include an electrical, electronic, or mechanical device that operates by receiving power from the battery pack 1. For example, the target device may be an electric vehicle (EV) or an energy storage system (ESS), but is not limited thereto.

According to an embodiment, the battery unit 12 may include at least one battery cell 10 that is rechargeable and dischargeable. Here, the battery cell 10 may be a basic unit of a battery cell that may be used by being charged and discharged with electric energy. For example, the battery cell 10 may be a lithium ion (Li-ion) battery, a lithium ion (Li-ion) polymer battery, a nickel cadmium (Ni-Cd) battery, a nickel hydrogen (Ni-MH) battery, or the like, and may not be limited thereto.

According to an embodiment, a plurality of battery units 12 may be connected in series or in parallel. For example, the battery unit 12 may be a battery module, a battery bank, or a collection of battery cells (cell-to-pack structure).

According to an embodiment, the sensor unit 14 may acquire information related to the battery unit 12. According to an embodiment, the sensor unit 14 may acquire values (or information) associated with the state of each of the battery units 12 or battery cells 10. In an embodiment, the state-related values may include at least one value for voltage, current, resistance, state of charge (SOC), state of health (SOH), or temperature of the battery cell, or a combination thereof.

According to an embodiment, the sensor unit 14 may provide information on each of the plurality of battery units 12 to the battery management system 20.

According to an embodiment, the switching unit 16 may include a device for controlling the current flow for charging or discharging the battery unit 12. For example, the switching unit 16 may include at least one relay and/or magnetic contactor, depending on the specifications of the battery pack 1.

According to an embodiment, the battery management system (BMS) 20 may control or manage the battery pack 1 by monitoring the voltage, current, temperature, and the like of the battery pack 1. For example, the battery management system 20 may be an interface for receiving values obtained by measuring the above-mentioned various parameters, and may include a plurality of terminals, a circuit connected to the terminals to process input values, or the like. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of the relay, the contactor, or the like.

According to an embodiment, the operation of the battery management system 20 may be performed by the BMS (battery management system) in a vehicle, as well as by various devices such as a server, a cloud, a charger, a discharger, or the like.

An upper-level controller 2 may transmit a control signal for the plurality of battery units 12 to the battery management system 20. Accordingly, the operation of the battery management system 20 may be controlled based on the signal received from the upper-level controller 2.

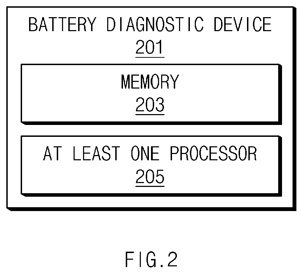

According to an embodiment, the battery management system 20 may include a battery diagnostic device 201 in FIG. 2. According to another embodiment, the battery management system 20 may be a system different than the battery diagnostic device 201 in FIG. 2. That is, the battery diagnostic device 201 in FIG. 2 may be included in the battery pack 1 or may be configured as another device external to the battery pack 1. For convenience of explanation, the following description assumes that the battery diagnostic device 201 is constructed as another device external to the battery pack 1. In addition, the operation of the battery diagnostic device 201 below may be performed by a battery management system (BMS) in the vehicle, as well as by various devices such as a server, a cloud, a charger, a discharger, or the like.

FIG. 2 is a block diagram illustrating the configuration of the battery diagnostic device, in the battery diagnostic device and the battery diagnosis method according to an embodiment of the present disclosure.

Referring to FIG. 2, the battery diagnostic device 201 may include a memory 203 storing at least one instruction and at least one processor 205 executing the at least one instruction. A battery unit (e.g., a battery pack, a battery module, or a battery cell) may include at least one battery cell and an auxiliary element associated with the at least one battery cell.

According to an embodiment, at least one processor 205 of the battery diagnostic device 201 may identify whether a battery cell is abnormal based on data of the battery cell (e.g., voltage data, current data and temperature data).

According to an embodiment, when a battery cell abnormality is diagnosed based on data of at least one battery cell included in a battery unit (e.g., slave) including some battery cells in the entire battery, the size of noise may be smaller than the size of noise when a battery cell abnormality is diagnosed based on data of at least one battery cell included in the entire battery. This is because relatively short electrical paths are formed between the battery cells included in the battery unit, thereby reducing noise or interference in electrical signals. The slave is an electrical unit that includes at least one battery cell in the entire battery, and is capable of performing control and monitoring.

However, the amount of data used for a diagnostic criterion for abnormalities when the diagnosis is performed based on data of at least one battery cell included in the entire battery may be greater than the amount of data used for the diagnostic criterion for abnormalities when the diagnosis is performed based on data of at least one battery cell included in the battery unit.

The accuracy of diagnosing the battery cell for abnormalities may be improved as the magnitude of noise decreases and the amount of data used for setting diagnostic criteria increases.

At least one processor 205 of the battery diagnostic device 201 according to an embodiment may set the diagnostic criterion for diagnosing a battery cell based on data included in the battery unit at a past point in time, in order to reduce noise and increase the amount of data used for setting diagnostic criterion for abnormalities.

Specifically, at least one processor 205 of the battery diagnostic device 201 may identify the voltage of any one battery cell included in the battery unit at a specific point in time and the voltage change amount over a predetermined time interval after the specific point in time.

The voltage change amount over the predetermined time interval may include a difference between a voltage value at a first point in time at which voltage data is acquired and a voltage value at a second point in time after a determined time interval from the first point in time and immediately after the first point in time. However, the embodiments of the present disclosure may not be limited thereto. For example, the voltage change amount over the predetermined time interval may include a difference between a voltage value at a third point in time and a voltage value at a fourth point in time after a determined time interval from the third point in time.

According to an embodiment, at least one processor 205 of the battery diagnostic device 201 may identify an individual vector by normalizing a vector including a voltage of any one battery cell included in the battery unit and the voltage change amount to.

Normalization of a vector may refer to adjusting the magnitude of each element included in the vector so that the magnitude of the vector becomes a specified value (e.g., 1) and a ratio between the elements included in the vector remains the same. For example, the normalization of a vector may include an operation of dividing each of the elements included in the vector by the magnitude of the vector.

According to an embodiment, after normalizing the vector including the voltage of any one battery cell at each of a plurality of past points in time and the voltage change amount over a time interval after each of the plurality of past points in time, at least one processor 205 of the battery diagnostic device 201 may identify, from the memory, existing vectors stored in the memory at respective ones of the plurality of past points in time. The memory may be referred to as a vector repository, or a vector store, but the embodiments of the present disclosure may not be limited thereto.

According to an embodiment, at least one processor 205 of the battery diagnostic device 201 may identify a specified number of reference vectors among the existing vectors, according to a similarity between each existing vector and the individual vector.

The similarity between the existing vector and the individual vector may be identified based on at least one of a distance between the existing vector and the individual vector, an angle between the existing vector and the individual vector, a Gaussian similarity between the existing vector and the individual vector, a Manhattan distance between the existing vector and the individual vector, a Mahalanobis distance between the existing vector and the individual vector, or any combination thereof, but embodiments of the present disclosure may not be limited thereto.

For example, at least one processor 205 of the battery diagnostic device 201 may identify a specified number of reference vectors in order of proximity to the individual vector, among existing vectors. However, the embodiments of the present disclosure may not be limited thereto.

For another example, at least one processor 205 of the battery diagnostic device 201 may identify a specified number of reference vectors among the existing vectors in ascending order of the angle between each existing vector and the individual vector. However, the embodiments of the present disclosure may not be limited thereto.

According to an embodiment, at least one processor 205 of the battery diagnostic device 201 may identify a first distribution characteristic among voltages of unit battery cells at a specific point in time corresponding to the individual vector. The unit battery cells may represent at least one battery cell included in the battery unit. The first distribution characteristic may include standard deviation or variance, but the embodiments of the present disclosure may not be limited thereto.

According to an embodiment, at least one processor 205 of the battery diagnostic device 201 may identify second distribution characteristics among voltages of unit battery cells at past points in time corresponding to each of the reference vectors. The second distribution characteristic may include standard deviation or variance, but the embodiments of the present disclosure may not be limited thereto.

According to an embodiment, at least one processor 205 of the battery diagnostic device 201 may identify representative values of the first distribution characteristic (e.g., a first standard deviation) and the second distribution characteristics (e.g., a second standard deviation).

For example, at least one processor 205 of the battery diagnostic device 201 may identify representative values of the first distribution characteristic and the second distribution characteristics based on a sum of a value obtained by applying a first weight to the first distribution characteristic and a sum of values obtained by applying a second weight to each of the second distribution characteristics. However, the embodiments of the present disclosure may not be limited thereto.

Here, the first weight may be smaller than the second weight. This is because battery cells at a past point in time are assumed to be normal battery cells. Any abnormal battery cell present among the battery cells at that past point in time would have been detected.

According to an embodiment, at least one processor 205 of the battery diagnostic device 201 may identify different representative values for battery cells other than the battery cell among the unit battery cells at a specific point in time. The other representative values may be expressions intended to indicate that they are representative values for other battery cells, rather than having a different size from the representative values.

That is, at least one processor 205 of the battery diagnostic device 201 may identify representative values for all unit battery cells at a specific point in time.

According to an embodiment, at least one processor 205 of the battery diagnostic device 201 may identify an average of representative values for all unit battery cells. The representative values for all unit battery cells may represent the representative values and the other representative values.

According to an embodiment, at least one processor 205 of the battery diagnostic device 201 may identify a threshold deviation using the average of representative values for all unit battery cells. At least one processor 205 of the battery diagnostic device 201 may identify a threshold median value based on a median value of voltage change amounts of the respective unit battery cells at the specific point in time.

According to an embodiment, at least one processor 205 of the battery diagnostic device 201 may identify an upper limit value of a threshold range based on a value obtained by adding the threshold deviation to the threshold median value, and may identify a lower limit value of the threshold range based on a value obtained by subtracting the threshold deviation from the threshold median value.

According to an embodiment, based on the voltage change amount of any one battery cell included in the battery unit being outside the threshold range, at least one processor 205 of the battery diagnostic device 201 may diagnose the one battery cell as abnormal.

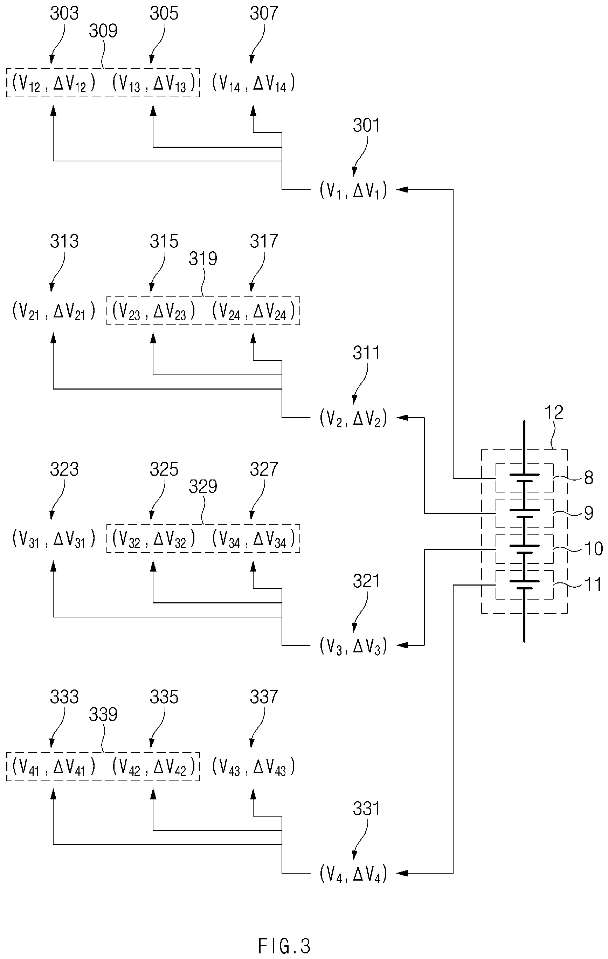

FIG. 3 illustrates an example of individual vectors, existing vectors, and reference vectors, in the battery diagnostic device and the battery diagnosis method according to an embodiment of the present disclosure.

Referring to FIG. 3, a battery unit 12 may include a first battery cell 8, a second battery cell 9, a third battery cell 10, and a fourth battery cell 11.

According to an embodiment, at least one processor (e.g., at least one processor 205 in FIG. 2) of a battery diagnostic device (e.g., a battery diagnostic device 201 in FIG. 2) may identify an individual vector (e.g., a first individual vector 301, a second individual vector 311, a third individual vector 321, or a fourth individual vector 331) corresponding to a battery cell (e.g., the first battery cell 8, the second battery cell 9, the third battery cell 10, or the fourth battery cell 11) based on data (e.g., a voltage or a voltage change amount) of the battery cell.

Specifically, at least one processor of the battery diagnostic device 201 (e.g., at least one processor 205 in FIG. 2) may identify the individual vector (e.g., the first individual vector 301, the second individual vector 311, the third individual vector 321, or the fourth individual vector 331) based on a voltage of any one battery cell (e.g., the first battery cell 8, the second battery cell 9, the third battery cell 10, or the fourth battery cell 11) included in the battery unit at a specific point in time and the voltage change amount over a predetermined time interval after the specific point in time.

According to an embodiment, at least one processor 205 of the battery diagnostic device 201 may identify, based on individual vectors (e.g., the first individual vector 301, the second individual vector 311, the third individual vector 321, and the fourth individual vector 331), existing vectors (e.g., a first existing vector 303, a second existing vector 305, a third existing vector 307, a fourth existing vector 313, a fifth existing vector 315, a sixth existing vector 317, a seventh existing vector 323, an eighth existing vector 325, a ninth existing vector 327, a tenth existing vector 333, an eleventh existing vector 335,and a twelfth existing vector 337) at respective ones of a plurality of past points in time before the specific point in time, corresponding to the individual vectors.

Specifically, after the vector including the voltage of the battery cell at each of a plurality of past points in time and the voltage change amount over a time interval after each of the plurality of past points in time is normalized, at least one processor 205 of the battery diagnostic device 201 may identify, from the memory, existing vectors stored in the memory at respective ones of the plurality of past points in time.

According to an embodiment, at least one processor 205 of the battery diagnostic device 201 may identify a specified number of reference vectors among existing vectors corresponding to the individual vector.

For example, at least one processor 205 of the battery diagnostic device 201 may identify the first existing vector 303 and the second existing vector 305 as reference vectors among the existing vectors corresponding to the first battery cell 8, may identify the fifth existing vector 315 and the sixth existing vector 317 as reference vectors among the existing vectors corresponding to the second battery cell 9, may identify the eighth existing vector 325 and the ninth existing vector 327 as reference vectors among the existing vectors corresponding to the third battery cell 10, and may identify the tenth existing vector 333 and the eleventh existing vector 335 as reference vectors among the existing vectors corresponding to the fourth battery cell 11. Points in time at which the existing vectors are acquired may be independent of each other.

For example, when identifying reference vectors for the first battery cell 8, at least one processor 205 of the battery diagnostic device 201 may identify a specified number of reference vectors (e.g., the first existing vector 303 and the second existing vector 305) in order of proximity to the individual vector (e.g., the first individual vector 301) among the existing vectors (the first existing vector 303, the second existing vector 305, and the third existing vector 307). However, the embodiments of the present disclosure may not be limited thereto.

According to an embodiment, at least one processor 205 of the battery diagnostic device 201 may identify a first distribution characteristic among voltages of unit battery cells at a specific point in time corresponding to an individual vector, and second distribution characteristics among voltages of the unit battery cells at a past point in time corresponding to each of the reference vectors.

For example, when identifying the first distribution characteristic and the second distribution characteristic for the first battery cell 8, at least one processor 205 of the battery diagnostic device 201 may identify the first distribution characteristic among the voltages of the unit battery cells (e.g., the first battery cell 8, the second battery cell 9, the third battery cell 10, and the fourth battery cell 11) at a specific point in time corresponding to the individual vector (e.g., the first individual vector 301), and the second distribution characteristics among the voltages of the unit battery cells at a past point in time corresponding to each of the reference vectors (e.g., the first existing vector 303 and the second existing vector 305).

According to an embodiment, at least one processor 205 of the battery diagnostic device 201 may identify representative values of the first distribution characteristic (e.g., a first standard deviation) and the second distribution characteristics (e.g., a second standard deviation).

For example, when identifying the representative value for the first battery cell 8, at least one processor 205 of the battery diagnostic device 201 may identify an average value of the first distribution characteristic and the second distribution characteristic.

For example, at least one processor 205 of the battery diagnostic device 201 may identify, at the specific point in time, representative values corresponding to battery cells (e.g., the second battery cell 9, the third battery cell 10, and the fourth battery cell 11) different from a battery cell (e.g., the first battery cell 8), among the unit battery cells (e.g., the first battery cell 8, the second battery cell 9, the third battery cell 10, and the fourth battery cell 11).

According to an embodiment, at least one processor 205 of the battery diagnostic device 201 may identify an average of representative values for all unit battery cells.

According to an embodiment, at least one processor 205 of the battery diagnostic device 201 may identify a threshold deviation using the average of representative values for all unit battery cells. At least one processor 205 of the battery diagnostic device 201 may identify a threshold median value based on a median value of voltage change amounts of the respective unit battery cells at the specific point in time.

According to an embodiment, at least one processor 205 of the battery diagnostic device 201 may identify an upper limit value of the threshold range based on a value obtained by adding the threshold deviation to the threshold median value, and may identify a lower limit value of the threshold range based on a value obtained by subtracting the threshold deviation from the threshold median value.

According to an embodiment, based on the voltage change amount of any one battery cell included in the battery unit being outside the threshold range, at least one processor 205 of the battery diagnostic device 201 may diagnose the one battery cell as abnormal.

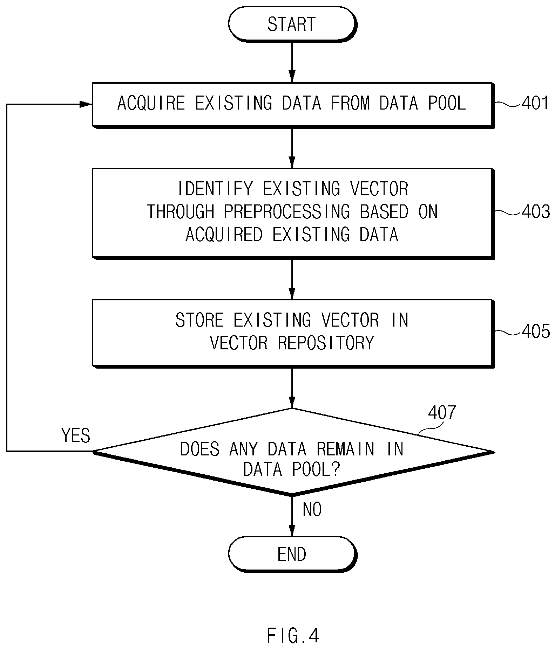

FIG. 4 illustrates an example of a flow of operations of a battery diagnostic device for storing a vector, in the battery diagnostic device and the battery diagnosis method according to an embodiment of the present disclosure.

Hereinafter, it is assumed that at least one processor 205 of the battery diagnostic device 201 in FIG. 2 performs the process of FIG. 4. In addition, in the description of FIG. 4, it may be understood that the operations described as being performed by the battery diagnostic device 201 are controlled by at least one processor 205 of the battery diagnostic device 201.

Referring to FIG. 4, in first operation 401, at least one processor 205 of the battery diagnostic device 201 according to an embodiment may acquire existing data from a data pool.

The data pool may store the existing data to correspond to a point in time at which data of the battery cell is acquired. The existing data may include data of battery cells (e.g., voltage data, current data, and temperature data) at each of a plurality of past points in time.

In second operation 403, at least one processor 205 of the battery diagnostic device 201 according to an embodiment may identify an existing vector through preprocessing based on the acquired existing data. The preprocessing process may include a process of identifying the existing vector by converting the existing data into a vector including the voltage of any one battery cell at each of the plurality of past points in time and the voltage change amount over a time interval after each of the plurality of past points in time, and then performing normalization on the vector.

In third operation 405, at least one processor 205 of the battery diagnostic device 201 according to an embodiment may store an existing vector in a vector repository. The vector repository may be referred to as a memory, but embodiments of the present disclosure may not be limited thereto.

In fourth operation 407, at least one processor 205 of the battery diagnostic device 201 according to an embodiment may identify whether any data remains in the data pool. When any data remains in the data pool, at least one processor 205 of the battery diagnostic device 201 may perform first operation 401. When no data remains in the data pool, the operation of the battery diagnostic device for storing the existing vector may be terminated.

According to an embodiment, the battery diagnostic device 201 may store the existing vector in the vector repository by performing first operation 401 to fourth operation 407.

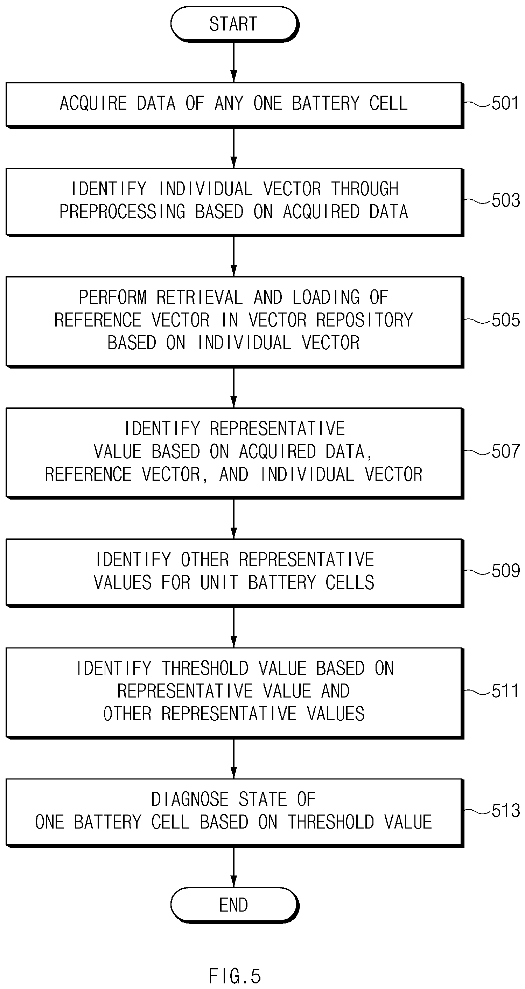

FIG. 5 illustrates a flow of operations of the battery diagnostic device for diagnosing a state of a battery cell based on a threshold value, in the battery diagnostic device and the battery diagnosis method according to an embodiment of the present disclosure.

Hereinafter, it is assumed that at least one processor 205 of the battery diagnostic device 201 in FIG. 2 performs the process of FIG. 5. In addition, in the description of FIG. 5, it may be understood that the operations described as being performed by the battery diagnostic device 201 are controlled by at least one processor 205 of the battery diagnostic device 201.

In first operation 501, at least one processor 205 of the battery diagnostic device 201 according to an embodiment may acquire data of any one battery cell.

In second operation 503, at least one processor 205 of the battery diagnostic device 201 according to an embodiment may identify an individual vector through preprocessing based on the acquired data.

In third operation 505, at least one processor 205 of the battery diagnostic device 201 according to an embodiment may perform retrieval and loading of a reference vector in the vector repository based on the individual vector.

In fourth operation 507, at least one processor 205 of the battery diagnostic device 201 according to an embodiment may identify a representative value based on the acquired data, the reference vector, and the individual vector.

In fifth operation 509, at least one processor 205 of the battery diagnostic device 201 according to an embodiment may identify other representative values for the unit battery cells.

In sixth operation 511, at least one processor 205 of the battery diagnostic device 201 according to an embodiment may identify a threshold value based on the representative value and other representative values.

In seventh operation 513, at least one processor 205 of the battery diagnostic device 201 according to an embodiment may diagnose the state of the one battery cell based on the threshold value.

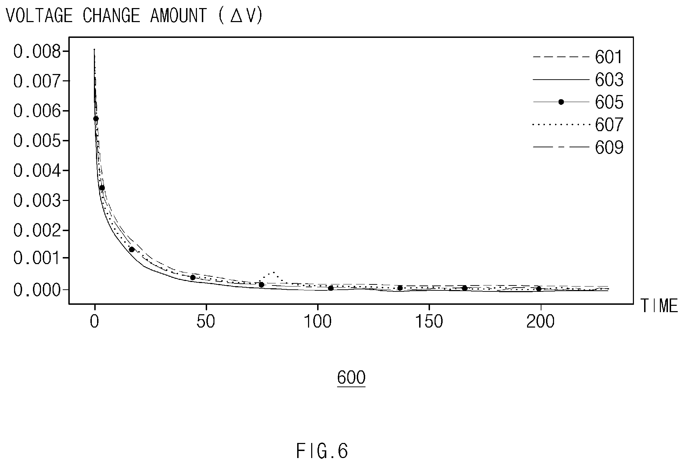

FIG. 6 illustrates a graph showing a voltage change amount over time, in the battery diagnostic device and the battery diagnosis method according to an embodiment of the present disclosure.

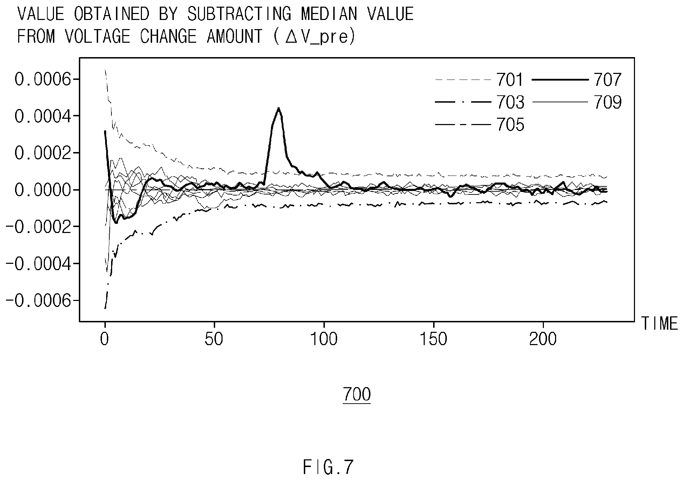

FIG. 7 illustrates a graph showing a value obtained by subtracting a median value from a voltage change amount over time, in the battery diagnostic device and the battery diagnosis method according to an embodiment of the present disclosure.

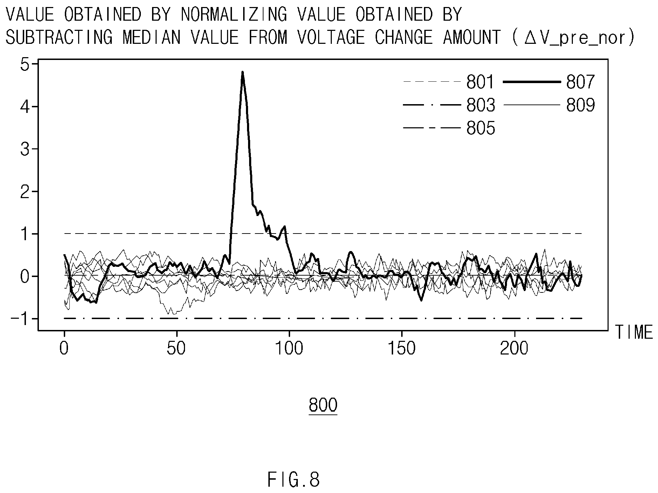

FIG. 8 illustrates a graph representing a value obtained by normalizing the value obtained by subtracting the median value from the voltage change amount, in the battery diagnostic device and the battery diagnosis method according to an embodiment of the present disclosure.

Referring to FIGS. 6 to 8, a first graph 600 may include first lines 609 indicating voltage change amounts of normal battery cells, a second line 607 indicating a voltage change amount of an abnormal battery cell, a fourth line 601 indicating an upper limit value of a threshold range, a fifth line 603 indicating a lower limit value of the threshold range, and a third line 605 identified based on a median value of voltage change amounts of respective unit battery cells at a specific point in time and indicating a threshold median value.

A second graph 700 may include sixth lines 709 indicating values obtained by subtracting the threshold median value of the first graph 600 from voltage change amounts of the normal battery cells of the first graph 600, a seventh line 707 indicating a value obtained by subtracting the threshold median value of the first graph 600 from the voltage change amount of the abnormal battery cell of the first graph 600, a ninth line 701 indicating a value obtained by subtracting the threshold median value of the first graph 600 from the upper limit value of the threshold range of the first graph 600, a tenth line 703 indicating a value obtained by subtracting the threshold median value of the first graph 600 from the lower limit value of the threshold range of the first graph 600, and an eighth line 705 indicating a value obtained by subtracting the threshold median value of the first graph 600 from the threshold median value of the first graph 600.

A third graph 800 may include an eleventh line 809 obtained by normalizing, by a size of the threshold range, the sixth lines 709 of the second graph 700 that indicate values obtained by subtracting the threshold median value from the voltage change amounts of the normal battery cells, a twelfth line 807 obtained by normalizing, by a size of the threshold range, the seventh line 707 indicating the value obtained by subtracting the threshold median value from the voltage change amount of the abnormal battery cell, a fourteenth line 801 obtained by normalizing, by a size of the threshold range, the ninth line 701 indicating the value obtained by subtracting the threshold median value from the upper limit value of the threshold range, a fifteenth line 803 obtained by normalizing, by a size of the threshold range, the tenth line 703 indicating the value obtained by subtracting the threshold median value from the lower limit value of the threshold range, and a thirteenth line 705 obtained by normalizing, by a size of the threshold range, the eighth line 705 indicating the value obtained by subtracting the median value from the threshold median value.

According to an embodiment, at least one processor 205 of the battery diagnostic device 201 may diagnose a battery cell corresponding to the twelfth line 807 as abnormal based on identifying that at least a portion of the twelfth line 807 is outside the threshold range between the fourteenth line 801 and the fifteenth line 803.

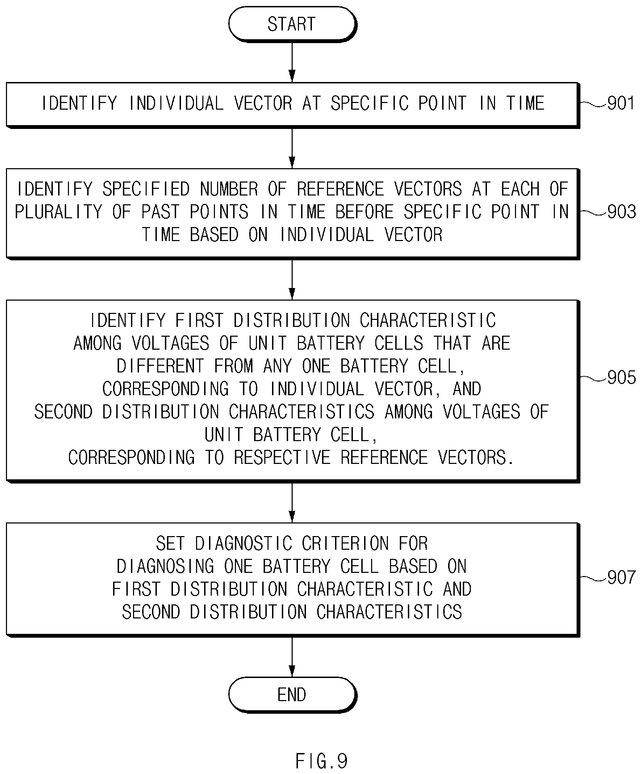

FIG. 9 illustrates a flow of operations of the battery diagnostic device for setting a diagnostic criterion, in the battery diagnostic device and the battery diagnosis method, according to an embodiment of the present disclosure.

Hereinafter, it is assumed that at least one processor 205 of the battery diagnostic device 201 in FIG. 2 performs the process of FIG. 9. In addition, in the description of FIG. 9, it may be understood that the operations described as being performed by the battery diagnostic device 201 are controlled by at least one processor 205 of the battery diagnostic device 201.

Referring to FIG. 9, in first operation 901, at least one processor 205 of the battery diagnostic device 201 according to an embodiment may identify an individual vector at a specific point in time.

In second operation 903, at least one processor 205 of the battery diagnostic device 201 according to an embodiment may identify, based on the individual vector, a specified number of reference vectors at each of a plurality of past points in time before the specific point in time.

In third operation 905, at least one processor 205 of the battery diagnostic device 201 according to an embodiment may identify a first distribution characteristic among voltages of unit battery cells that are different from any one battery cell, corresponding to the individual vector, and second distribution characteristics among voltages of the unit battery cells, corresponding to respective reference vectors.

In fourth operation 907, at least one processor 205 of the battery diagnostic device 201 according to an embodiment may set a diagnostic criterion for diagnosing the one battery cell based on the first distribution characteristic and the second distribution characteristics.

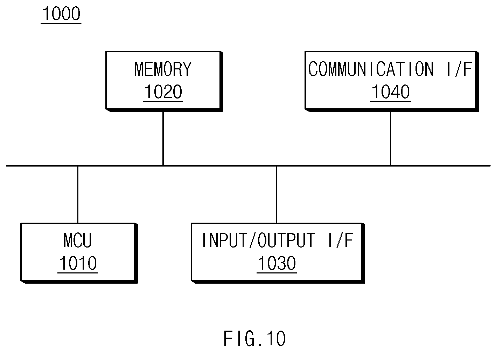

FIG. 10 is a block diagram showing a hardware configuration of a computing system for performing a battery diagnosis method according to an embodiment of the present disclosure.

Referring to FIG. 10, a computing system 1000 according to an embodiment of the present disclosure may include a microcontroller unit (MCU) 1010, a memory 1020, an input/output interface (I/F) 1030, and a communication I/F 1040.

The MCU 1010 may be at least one processor that executes various programs (e.g., a battery cell data collection program, a graph generation program, a data analysis program, a data decomposition algorithm, a normalization program, a battery cell diagnosis program, and the like) stored in the memory 820, processes various pieces of information including battery cell characteristic data, latent variables, and the like through the programs, and performs functions of the battery diagnostic device 201 shown in the above-described FIGS. 1 to 9.

The memory 1020 may store various programs such as the battery cell data collection program, the graph generation program, the data analysis program, the data decomposition algorithm, the normalization program, the battery cell diagnosis program, and the like.

A plurality of memories 1020 may be provided as needed. The memory 1020 may be a volatile memory or a non-volatile memory. As the volatile memory, the memory 1020 may be a random-access memory (RAM), a dynamic RAM (DRAM), a static RAM (SRAM), or the like. For the memory 1020 as the non-volatile memory, a read-only memory (ROM), a programmable ROM (PROM), an electrically alterable ROM (EAROM), an erasable programmable ROM (EPROM), an electrically erasable programmable ROM (EEPROM,) a flash memory, or the like may be used. The examples of memories 1020 listed above are only exemplary and are not limited to the examples.

The input/output I/F 1030 may provide an interface that connects an input device (not shown) such as a keyboard, mouse, touch panel, or the like, and an output device such as a display (not shown), to the MCU 1010 to enable data transmission and reception.

The communication I/F 1040 is a component that may transmit and receive various data to and from the server, and may be any device that may support wired or wireless communication. For example, the battery diagnostic device 201 may transmit and receive various types of information, including a shape model of a battery cell or the like, to and from a separately provided external server through the communication I/F 1040.

By being recorded in the memory 1020 and processed by the MCU 1010 in this way, a computer program according to an embodiment disclosed herein may be implemented, for example, as a functional module that performs each of the functions shown in FIG. 2.

Although all the components constituting the embodiments disclosed herein have been described as being combined or operating in combination as one, the embodiments disclosed herein are not necessarily limited to these embodiments. That is, within the scope of the purpose of the embodiments disclosed herein, all of the components may be selectively combined and operated one or more times.

Terms such as "include," "comprise," or "have" described above mean that the corresponding component may be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The foregoing disclosure outlines features of several embodiments so that those skilled in the art may better understand the aspects of the present disclosure. Those skilled in the art will appreciate that the present disclosure may readily serve as a basis for designing or modifying other structures for carrying out the same purposes or achieving the same advantages of the embodiments introduced herein. Furthermore, those skilled in the art will recognize that such equivalent configurations do not depart from the scope of the present disclosure, and that various changes, substitutions, and modifications may be made herein without departing from the scope of the present disclosure.

## Claims

1. A battery diagnostic device comprising:
a memory storing at least one instruction; and
at least one processor executing the at least one instruction,
wherein the at least one processor is configured to:
identify an individual vector representing a voltage of any one battery cell included in a battery unit at a specific point in time and a voltage change amount over a predetermined time interval after the specific point in time;
identify, based on the individual vector, a specified number of reference vectors at each of a plurality of past points in time before the specific point in time;
identify a first distribution characteristic among voltages of unit battery cells included in the battery unit, corresponding to the individual vector, and second distribution characteristics among voltages of the unit battery cells, corresponding to respective reference vectors; and
set a diagnostic criterion for diagnosing the one battery cell based on the first distribution characteristic and the second distribution characteristics.

2. The battery diagnostic device of claim 1, wherein the at least one processor is configured to:
identify representative values of the first distribution characteristic and the second distribution characteristics;
identify other representative values for other battery cells different from the battery cell among the unit battery cells at a specific point in time, corresponding to the representative values; and
diagnose a state of the one battery cell included in the battery unit based on the representative values and the other representative values.

3. The battery diagnostic device of claim 1, wherein the at least one processor is configured to identify a specified number of reference vectors, among existing vectors representing the voltage of the one battery cell at each of the plurality of past points in time and the voltage change amount over the time interval after each of the plurality of past points in time, according to a similarity between each of the existing vectors and the individual vector.

4. The battery diagnostic device of claim 3, wherein the at least one processor is configured to identify the specified number of reference vectors among the existing vectors in order of proximity to the individual vector.

5. The battery diagnostic device of claim 2, wherein the at least one processor is configured to:
identify an average of the representative values and the other representative values;
identify a threshold value that serves as the diagnostic criterion for diagnosing the one battery cell for abnormalities at the specific point in time based on the average; and
diagnose the state of the one battery cell based on the threshold value.

6. The battery diagnostic device of claim 5, wherein the at least one processor is configured to:
identify the threshold value based on the average and a median value of the voltage change amounts of the respective unit battery cells at the specific point in time; and
diagnose the one battery cell for abnormalities based on the voltage change amount of the one battery cell being outside a threshold range identified based on the threshold value.

7. The battery diagnostic device of claim 1, wherein the at least one processor is configured to identify the individual vector by normalizing a vector including the voltage of the one battery cell at the specific point in time and the voltage change amount over the time interval after the specific point in time.

8. The battery diagnostic device of claim 3, wherein the at least one processor is configured to identify the existing vectors normalized at each of the plurality of past points in time and then stored in the memory by normalizing a vector including the voltage of the one battery cell at each of the plurality of past points in time and the voltage change amount over the time interval after each of the plurality of past points in time.

9. The battery diagnostic device of claim 1, wherein the first distribution characteristic includes a first standard deviation between voltages corresponding to the individual vectors of the unit battery cells, and
the second distribution characteristic includes a second standard deviation between voltages corresponding to the respective reference vectors of the unit battery cells.

10. The battery diagnostic device of claim 9, wherein the at least one processor is configured to identify representative values of the first distribution characteristic and the second distribution characteristics based on a value obtained by applying a first weight to the first standard deviation and values obtained by applying a second weight to each of second standard deviations.

11. The battery diagnostic device of claim 10, wherein the at least one processor is configured to identify the representative values based on the value obtained by applying the first weight to the first standard deviation and a sum of the values obtained by applying the second weight to each of the second standard deviations.

12. The battery diagnostic device of claim 10, wherein the first weight is smaller than the second weight.

13. A battery diagnosis method comprising:
identifying an individual vector representing a voltage of any one battery cell included in a battery unit at a specific point in time and a voltage change amount over a predetermined time interval after the specific point in time;
identifying, based on the individual vector, a specified number of reference vectors at each of a plurality of past points in time before the specific point in time;
identifying a first distribution characteristic among voltages of unit battery cells included in the battery unit, corresponding to the individual vector, and second distribution characteristics among voltages of the unit battery cells, corresponding to respective reference vectors; and
setting a diagnostic criterion for diagnosing the one battery cell based on the first distribution characteristic and the second distribution characteristics.

14. The battery diagnosis method of claim 13, wherein the setting of the diagnostic criterion for diagnosing the one battery cell based on the first distribution characteristic and the second distribution characteristics includes:
identifying representative values of the first distribution characteristic and the second distribution characteristics;
identifying other representative values for other battery cells different from the battery cell among the unit battery cells at a specific point in time, corresponding to the representative values; and
diagnosing a state of the one battery cell included in the battery unit based on the representative values and the other representative values.

15. The battery diagnosis method of claim 13, wherein the identifying, based on the individual vector, of the specified number of reference vectors at each of the plurality of past points in time before the specific point in time includes identifying a specified number of reference vectors, among existing vectors representing the voltage of the one battery cell at each of the plurality of past points in time and the voltage change amount over the time interval after each of the plurality of past points in time, according to a similarity between each of the existing vectors and the individual vector.

16. The battery diagnosis method of claim 15, wherein the identifying of the specified number of reference vectors, among existing vectors representing the voltage of the one battery cell at each of the plurality of past points in time and the voltage change amount over the time interval after each of the plurality of past points in time, according to the similarity between each of the existing vectors and the individual vector includes identifying the specified number of reference vectors among the existing vectors in order of proximity to the individual vector.

17. The battery diagnosis method of claim 14, wherein the diagnosing of the state of the one battery cell included in the battery unit based on the representative values and the other representative values includes:
identifying an average of the representative values and the other representative values;
identifying a threshold value that serves as the diagnostic criterion for diagnosing the one battery cell for abnormalities at the specific point in time based on the average; and
diagnosing the state of the one battery cell based on the threshold value.

18. The battery diagnosis method of claim 17, wherein the identifying of the threshold value that serves as the diagnostic criterion for diagnosing the one battery cell for abnormalities at the specific point in time based on the average includes identifying the threshold value based on the average and a median value of the voltage change amounts of the respective unit battery cells at the specific point in time, and
the diagnosing of the state of the one battery cell based on the threshold value includes diagnosing the one battery cell for abnormalities based on the voltage change amount of the one battery cell being outside a threshold range identified based on the threshold value.

19. The battery diagnosis method of claim 13, wherein the identifying of the individual vector representing the voltage of the one battery cell included in a battery unit at the specific point in time and the voltage change amount over the predetermined time interval after the specific point in time includes identifying the individual vector by normalizing a vector including the voltage of the one battery cell at the specific point in time and the voltage change amount over the time interval after the specific point in time.

20. The battery diagnosis method of claim 15, wherein the identifying of the specified number of reference vectors, among existing vectors representing the voltage of the one battery cell at each of the plurality of past points in time and the voltage change amount over the time interval after each of the plurality of past points in time, according to the similarity between each of the existing vectors and the individual vector includes identifying the existing vectors normalized at each of the plurality of past points in time and then stored in the memory by normalizing a vector including the voltage of the one battery cell at each of the plurality of past points in time and the voltage change amount over the time interval after each of the plurality of past points in time.
